# EUROPÄISCHE PATENTANMELDUNG

(11) **EP 1 193 742 A2**
(43) Veröffentlichungstag der Anmeldung: **03.04.2002**
(21) Anmeldenummer: 01121460.8
(22) Anmeldetag: 07.09.2001
(51) Int. Cl.: H01L 21/28

(54) **Verfahren zum Herstellen von integrierten Schaltungsanordnungen sowie zugehörige Schaltungsanordnungen, insbesondere Tunnelkontaktelemente**

(30) Priorität: 29.09.2000 DE 10048420
(71) Anmelder: Infineon Technologies AG, 81669 München (DE)
(72) Erfinder: Engelhardt, Manfred, Dr., 83620 Feldkirchen-Westerham (DE); Wurm, Stefan, Dublin, CA 94568 (US)
(74) Vertreter: Barth, Stephan Manuel, Dr.

(57) **Zusammenfassung**

Die Erfindung betrifft unter anderem ein Verfahren, bei dem auf eine von einer Substratschicht (12) getragene elektrisch leitfähige Kontaktschicht eine elektrisch nicht leitfähige Maskenschicht (16) aufgebracht wird. In die Maskenschicht (16) wird ein Freiraum eingebracht. Anschließend werden im Freiraum elektrochemisch mehrere Schichten (52 bis 60) abgeschieden. Oberhalb der zuletzt abgeschiedenen Schicht (60) werden anschließend Schichten (72 und 76) aufgebracht. In einem Abtragungsprozess wird dann die Maskenschicht (16) bis auf die Höhe der obersten Schicht (76) abgetragen.

## Beschreibung

Die Erfindung betrifft ein Verfahren, bei dem eine elektrisch leitfähige Kontaktschicht von einer Substratschicht getragen wird, z.B. von einer Siliziumscheibe (Wafer). Auf die elektrisch leitfähige Kontaktschicht wird eine elektrisch nicht leitfähige Maskenschicht aufgebracht, z.B. ein Fotolack. Anschließend wird ein Teil der Maskenschicht entfernt, um danach mindestens eine elektrisch leitfähige Schicht auf die Kontaktschicht in dem entstandenen Freiraum aufzubringen.

Für nicht leitfähige Schichten, d.h. für Isolatorschichten, für Halbleiterschichten und für elektrisch leitfähige Schichten lassen sich etwa die folgenden spezifischen Leitfähigkeiten κ angeben:
- organische und anorganische Isolatoren κ = 10⁻¹⁸ bis 10⁻⁷ Ω⁻¹/m⁻¹,
- Halbleiter κ = 10⁻⁷ bis 10⁻⁴ Ω⁻¹/m⁻¹ und
- elektrisch leitfähige Schichten, insbesondere Metallschichten κ > 10⁴ Ω⁻¹/m⁻¹, insbesondere im Bereich κ = 10⁴ bis 10⁵ Ω⁻¹/m⁻¹.

Zum Aufbringen der elektrisch leitfähigen Schichten bei der Herstellung von integrierten Schaltungsanordnungen sind verschiedene Verfahren bekannt, unter anderem
- Bedampfen,
- Aufstäuben (Sputtern), und
- elektrochemische Abscheidung.

Beim Bedampfen und Aufstäuben entstehen auf der gesamten Siliziumscheibe Schichten, die zum einen über die Siliziumscheibe ungleichmäßig dick sein können. Andererseits haben Schichtabschnitte innerhalb von Freiräumen der Maskenschicht verschiedene Dicken, insbesondere in der Nähe von Stufen. Diese Nachteile sind für viele Anwendungen störend. Bedampfen und Aufstäuben ist sowohl zum Aufbringen elektrisch leitfähiger Schichten als auch zum Aufbringen elektrisch nicht leitfähiger Schichten möglich.

Mit elektrochemischen Beschichtungsverfahren lassen sich Schichten sehr gleichmäßiger Schichtdicke abscheiden. Es wird eine galvanische und eine außenstromlose Abscheidung unterschieden. Bei der galvanischen Metallabscheidung werden Elektronen von einer äußeren Stromquelle geliefert. Ein z-fach positiv geladenes Metallion wird unter Aufnahme von z Elektronen reduziert, wobei z eine natürliche Zahl größer 0 ist. Bei der außenstromlosen Abscheidung von Metallen wird keine äußere Stromquelle benötigt. Die zur Reduktion erforderlichen Elektronen stammen aus einem Reduktionsmittel, das in einer Elektrolytlösung enthalten ist. Das elektrochemische Abscheiden ist nur für elektrisch leitende Schichten möglich.

Es ist Aufgabe der Erfindung, zur Herstellung einer integrierten Schaltungsanordnung mit elektrisch leitenden und elektrisch nicht leitenden Schichten einfache Verfahren anzugeben. Außerdem sollen zugehörige integrierte Schaltungsanordnungen und ein Tunnelkontaktelement angegeben werden.

Die auf das Verfahren bezogene Aufgabe wird durch die im Patentanspruch 1 angegebenen Verfahrensschritte gelöst. Weiterbildungen sind in den Unteransprüchen angegeben.

Beim erfindungsgemäßen Verfahren wird zusätzlich zu den eingangs genannten Verfahrensschritten in dem beim Entfernen von Teilen der Maskenschicht entstandenen Freiraum mittels elektrochemischer Abscheidung mindestens eine elektrisch leitfähige Schicht elektrochemisch abgeschieden.

Beim elektrochemischen Abscheiden lagern sich auf der elektrisch nicht leitfähigen Maskenschicht keine Materialien ab.

Dadurch entfallen Schritte, mit denen solche Materialien entfernt werden müssten. Durch das Einsetzen eines elektrochemischen Beschichtungsverfahrens entstehen innerhalb des Freiraumes Schichten mit gleichmäßiger Dicke. Die Schichten können außerdem sehr dünn sein, z.B. kleiner als 2 nm. Die Dicke der Schichten ist sowohl innerhalb eines Freiraumes gleichmäßig als auch an verschiedenen Orten einer Siliziumscheibe von beispielsweise 200 oder 300 mm Durchmesser. Das elektrochemische Beschichten ist ein sehr kostengünstiges Beschichtungsverfahren im Vergleich zum Bedampfen oder zum Aufstäuben. Dadurch lässt sich der untere Teil des Schichtsystems mit vergleichsweise geringem Aufwand fertigen. Beim Herstellen von sehr dünnen Schichten erhöht sich die Ausbeute bei der Herstellung von integrierten Schaltungsanordnungen erheblich, weil die Dicke der abgeschiedenen Schichten technologisch vergleichsweise genau eingestellt werden kann.

Beim erfindungsgemäßen Verfahren wird außerdem in den Freiraum nach dem elektrochemischen Abscheiden eine elektrisch nicht leitende Schicht eingebracht. Damit ist eine elektrochemische Abscheidung weiterer Schichten nicht mehr möglich. Eine weitere Schicht oder mehrere weitere Schichten werden mit anderen Beschichtungstechniken in den Freiraum eingebracht. Die weitere Schicht bzw. die weiteren Schichten können elektrisch leitfähig, elektrisch nicht leitfähig oder halbleitend sein. Beim Aufbringen der weiteren Schicht bzw. der weiteren Schichten entstehen außerhalb des Freiraums Schichten aus den gleichen Materialien. Diese Schichten werden in einem Abtragungsprozess abgetragen.

Das herzustellende Bauelement liegt also bereits vor dem Abtragen im Freiraum. Maßnahmen zur seitlichen Begrenzung der aufgebrachten Schichten, wie sie bei herkömmlichen Beschichtungsverfahren oft erforderlich sind, entfallen. Solche Maßnahmen würden zu einer Materialvermischung an den Seitenrändern führen. Diese Materialvermischung hätte in ungünstigen Fällen eine Überbrückung der elektrisch nicht leitenden Schicht durch elektrisch leitende Materialien und damit einen elektrischen Kurzschluss zur Folge. Durch das erfindungsgemäße Verfahren wird jedoch eine solche Überbrückung gerade vermieden. Deshalb lassen sich Bauelemente mit hoher Ausbeute herstellen.

Beim erfindungsgemäßen Verfahren wird die zuletzt abgeschiedene Schicht in einem vorzugsweise anodisch ausgeführten Oxidationsvorgang vollständig oder teilweise zu einer elektrisch nicht leitenden Schicht oxidiert. Durch diese Maßnahme wird erreicht, dass die nicht leitende Schicht aus einer leitenden Schicht hergestellt werden kann. Bei der Oxidation verändert sich die Dicke der Schicht nur unwesentlich und gleichmäßig. Damit ist die nicht leitende Schicht gleichmäßig dick. Alternativ wird auf die zuletzt abgeschiedene Schicht eine elektrisch nicht leitende Schicht aufgebracht, z.B. durch Aufstäuben oder Bedampfen. Bei der Alternative wird für die aufgebrachte nicht leitfähige Schicht eine gleichmäßige Grundlage durch das Abscheiden der vorhergehenden Schichten erzeugt. Dies führt auch zu einer gleichmäßigeren nicht leitfähigen Schicht. Die nicht leitfähige Schicht ist in vielen Anwendungsfällen die bei der Herstellung kritische Schicht, z.B. die dünnste Schicht. Durch den Einsatz des erfindungsgemäßen Verfahrens kann die nicht leitende Schicht mit geringeren Toleranzen aufgebracht werden. Dies erhöht die Ausbeute bei der Herstellung der integrierten Schaltungsanordnung ebenfalls.

Wird galvanisch abgeschieden, das heißt mit Außenstrom, so bildet die elektrisch leitende Kontaktschicht bzw. bilden die darüber abgeschiedenen elektrisch leitenden Schichten die Anode. Beim Verwenden bestimmter Materialien für die elektrisch leitende Kontaktschicht, z.B. bei Kupfer oder hochdotierten Halbleitern, werden sogenannte Diffusionsbarrieren und/oder Haftschichten eingesetzt, im Folgenden als Zwischenschicht bezeichnet. Die Zwischenschicht besteht z.B. aus TaN (Tantal-Nitrid). Auch die Zwischenschicht kann als Anode für die galvanische Abscheidung genutzt werden. Reicht die Zwischenschicht bis in den Randbereich der bearbeiteten Siliziumscheibe (Wafer), so lässt sich Außenstrom über die Ränder der Siliziumscheibe auf einfache Weise zuführen. Zum Galvanisieren lässt sich Gleichstrom oder Wechselstrom einsetzten.

Bei einer Weiterbildung überlappt die Maskenschicht die elektrisch leitfähige Schicht allseitig. Bei der Weiterbildung werden mindestens zwei elektrisch leitfähige Schichten aus verschiedenen Materialien nacheinander abgeschieden. Durch das allseitige Überlappen wird erreicht, dass nur das erste Material an die elektrisch leitfähige Kontaktschicht gelangt. Die erste Schicht wird dann mit gleichmäßiger Dicke abgeschieden. Beim Abscheiden der zweiten Schicht gelangt kein Material dieser Schicht mehr an die elektrisch leitfähige Kontaktschicht. Die zweite elektrisch leitfähige Schicht wird über der zuvor aufgebrachten Schicht in gleichmäßiger Dicke abgeschieden. Auch die Randbereiche der Schichten haben im Vergleich zur übrigen Schicht die gleiche Dicke. Eine Krümmung in den Randbereichen aufgrund einer unterschiedlichen Schichtdicke tritt nicht auf.

Die Dicke der Maskenschicht wird, wie bereits erwähnt, so bemessen, dass auch die weitere Schicht unterhalb der Öffnung des Freiraumes liegt. Mit Hilfe eines Abtragungsprozesses werden bei einer Weiterbildung in einem späteren Verfahrensschritt außerhalb des Freiraums liegende Bereiche abgetragen, die beim Aufbringen der weiteren Schicht entstanden sind. Somit behindern diese Bereiche die weitere Herstellung der integrierten Schaltungsanordnung nicht mehr. Zum Abtragen wird beispielsweise ein mechanisch-chemischer Polierprozess (MCP) eingesetzt. Es lässt sich auch ein Teil der Maskenschicht abtragen. Der Rest der Maskenschicht verbleibt auf der Substratschicht und begrenzt das Schichtsystem innerhalb des Freiraums allseitig.

Bei einer nächsten Weiterbildung wird vor dem Polierprozess eine Versiegelungsschicht aufgebracht, die den noch nicht gefüllten Raum des Freiraumes einnimmt. Beim Polierprozess wird die Versiegelungsschicht bis auf die Höhe der zuletzt aufgebrachten Schicht abgetragen. Durch das Versiegeln wird erreicht, dass bei späteren Verfahrensschritten kein Material in den Zwischenraum zwischen den weiteren Schichten und der Maskenschicht gelangt. Durch solches Material würden die elektrischen Eigenschaften des Schichtsystems verändert werden.

Bei einer alternativen Weiterbildung wird die Maskenschicht beim Abtragungsprozess vollständig abgetragen, z.B. durch ein sogenanntes Lift-off-Verfahren. Dadurch werden auch die beim Aufbringen der weiteren Schicht außerhalb des Freiraums entstandenen Schichten entfernt und stören die weiteren Verfahrensschritte nicht.

Bei einer Weiterbildung der Alternative besteht die Maskenschicht aus einem organischen Material. Die Maskenschicht wird mit Hilfe eines geeigneten Lösungsmittels abgelöst. Geeignet als Material für die Maskenschicht sind alle organischen Materialien, die in der Halbleitertechnologie eingesetzt werden können. Der Trend geht zu organischen Materialien mit kleine Dielektrizitätswerten. Beispiele für solche Materialien sind Polyimide, die gegebenenfalls mit Fluor versetzt sind. Außerdem werden sogenannte Spin-on-Gläser eingesetzt, d.h. Gläser, die mit Hilfe des sogenannten Spin-Verfahrens auf die Substratschicht aufgebracht werden. Weitere Vertreter sind Alkylsilane, Ultra-low-k-Materialien, wie z.B. Teflon, poröse Dielektrika, wie z.B. Ärogel, oder auch SiLK, eine Kohlenwasserstoffverbindung, die kein Silizium enthält.

Bei einer Ausgestaltung wird nach dem Abtragen der Maskenschicht eine Kapselschicht aufgebracht. Die Kapselschicht wird bis auf die Höhe der zuletzt aufgebrachten Schicht abgetragen, vorzugsweise in einem mechanisch chemischen Polierprozess. Die Kapselschicht dient zum Kapseln des Schichtsystems, so dass bei den weiteren Verfahrensschritten keine Substanzen das Schichtsystem zerstören.

Bei einer anderen Weiterbildung werden Teile der Maskenschicht beispielsweise durch anisotropes Ätzen so entfernt, dass sich der Freiraum vorzugsweise allseitig zur Substratschicht hin verbreitert. Die entstehende Struktur wird auch als Reentrant-Struktur bezeichnet. Die Neigung der Wände des Freiraums , d.h. der Überhang beträgt beispielsweise mehr als 5 Prozent bezüglich der Normalen der Substratschicht. Eingesetzt werden beispielsweise Neigungswinkel von 5 Prozent, 10 Prozent oder 20 Prozent. Durch die Neigung wirkt die Maskenschicht beim Aufbringen der weiteren Schichten als sogenannte Schattenmaske. Beim Aufstäuben der weiteren Schichten werden zu starke Abflachungen in den Randbereichen der aufzubringenden Schicht durch die Schattenmaske vermieden. Es kann jedoch auch ohne Neigung der Seitenwände gearbeitet werden.

Bei einer nächsten Weiterbildung hat der Freiraum z.B. einen trapezförmigen Querschnitt. Die Seitenwände des Freiraums bilden entlang eines Querschnitts durch die Maskenschicht beispielsweise Geraden. Dies erleichtert das Herstellen des Freiraums erheblich. Jedoch werden auch Freiräume eingesetzt, die sich nur im Bereich der weiteren Schichten zur Substratschicht hin verbreitern und anschließend etwa gleiche Durchmesser haben.

Bei einer anderen Weiterbildung hat die Maskenschicht eine ebene Oberfläche und enthält eine Vielzahl von Aussparungen, in denen gleichartige Bauelemente angeordnet sind. Die Kontaktschichten mehrerer Bauelemente sind miteinander verbunden, beispielsweise nach Art einer Matrix in Zeilen und Spalten. Durch diese Maßnahme lässt sich beim Galvanisieren an die untereinander verbundenen Kontaktschichten auf einfache Art ein Strom einspeisen. Dadurch vereinfacht sich der Galvanisiervorgang auch bei sehr vielen Bauelementen, z.B. mehreren Hunderttausend Bauelementen auf einer integrierten Schaltungsanordnung. Mehrere integrierte Schaltungsanordnungen werden auf einer Siliziumscheibe mit einem Durchmesser von 200 mm, 300 mm oder größer hergestellt. Bei integrierten Schaltkreisen lässt sich die Kombination von elektrochemischer Abscheidung und anderen Beschichtungstechniken einsetzen und ist dem bisher verwendeten Verfahren zur Herstellung einer integrierten Schaltungsanordnung in vielen Punkten überlegen.

Bei einer Weiterbildung ist die Maskenschicht dünner als 100 nm, vorzugsweise dünner als 50 nm. Mindestens eine in den Hohlraum eingebrachte Schicht ist dünner als 5 nm. Insbesondere bei solchen Schichtdicken wird durch den Einsatz des erfindungsgemäßen Verfahrens oder dessen Weiterbildungen das Herstellen von wesentlich homogeneren und gleichmäßigeren Schichten als mit anderen Verfahren erreicht. Die genannten Schichtdicken werden beispielsweise bei der Herstellung von Tunnelkontaktelementen gefordert, d.h. bei Kontaktelementen, die den sogenannten Tunneleffekt von Elektronen durch Isolatoren ausnutzen.

Deshalb wird bei einer anderen Weiterbildung mindestens eine in den Freiraum eingebrachte elektrisch nicht leitfähige Schicht mit einer Dicke hergestellt, die so bemessen ist, dass Elektronen die Schicht nur aufgrund des Tunneleffektes durchqueren können.

Bei einer Ausgestaltung wird eine elektrisch leitfähige Schicht durch elektrochemische Abscheidung in den Freiraum eingebracht. Anschließend wird diese Schicht vorzugsweise durch anodische Oxidation zu einer elektrisch nicht leitfähigen Schicht oxidiert. Diese Technologie lässt sich insbesondere bei Tunnelelementen zur Erzielung einer hohen Ausbeute bei der Produktion einsetzen. Das Aufsputtern von sehr dünnen Schichten ist nämlich problematisch. Die anodische Oxidation hat im Vergleich zu anderen Oxidationsverfahren Vorzüge hinsichtlich der Oxidationszeit und der Gleichmäßigkeit der Oxidation.

Bei einer nächsten Weiterbildung werden folgende Materialien eingesetzt:
- für die Maskenschicht und/oder die Versiegelungsschicht ein Quarzglas oder ein organisches elektrisch nicht leitfähiges Material,
- für die zuletzt abgeschiedene Schicht z.B. Aluminium, und/oder
- für weitere im Freiraum abgeschiedene oder in den Freiraum aufgebrachte Schichten hartmagnetische Materialien und/oder Schichten aus weichmagnetischem Material.

Durch das Verwenden von hartmagnetischen und weichmagnetischen Schichten lassen sich magnetische Speicherelemente herstellen, die den Tunneleffekt ausnutzen. Solche Speicher sind unter dem Namen "Magnetic Random Access Memories" (MRAM) bekannt. Eingesetzte hartmagnetische Materialien sind:
- Ferromagnete wie z.B. FeMn, NiMn, IrMn und PtMn,
- sogenannte Pseudospinvalves wie z.B. CrPdMn, oder
- künstliche Antiferromagnete wie z.B. Co/Cu/Co, Fe/Cr/Fe, CoFe/Ru/CoFe.

Diesen Materialien ist gemeinsam, dass ein magnetisches Feld mit einer Feldstärke von z.B. mehr als 100 Oersted benötigt wird, um die Ausrichtung der Magnetisierung innerhalb der Materialien zu verändern.

Als weichmagnetische Schicht wird beispielsweise eine Schicht aus FeNi oder aus CoPt verwendet. Auch Kombinationen der hartmagnetischen und/oder der weichmagnetischen Schichten werden eingesetzt.

Die Erfindung betrifft außerdem eine Schaltungsanordnung, bei der mindestens eine Schicht eines Schichtsystems durch elektrochemische Abscheidung hergestellt worden ist. Die Maskenschicht ist älter als die durch elektrochemische Abscheidung hergestellte Schicht. Die Maskenschicht hat also eine Doppelfunktion. Sie dient als Schutz zum Kapseln des Schichtsystems und bildet eine seitliche Grenze bei der elektrochemischen Abscheidung. Damit gelten die oben genannten technischen Wirkungen auch für die Schaltungsanordnung.

Außerdem ist durch die Erfindung eine Schaltungsanordnung betroffen, bei der eine Kapselschicht ein Schichtsystem einschließt, das mindestens eine durch elektrochemische Abscheidung abgeschiedene Schicht enthält. Die Kapselschicht ist jünger als die abgeschiedene Schicht. Die oben genannten technischen Wirkungen gelten auch für die Schaltungsanordnung, insbesondere die im Zusammenhang mit der Maskenschicht und deren Abtragen angegebenen Wirkungen.

Das Schichtsystem enthält neben der durch elektrochemische Abscheidung abgeschiedenen Schicht bzw. neben den durch elektrochemische Abscheidung abgeschiedenen Schichten bei einer Weiterbildung der Schaltungsanordnung mit Kapselschicht mindestens eine elektrisch nicht leitende Schicht, über der weitere Schichten angeordnet sind.

Außerdem hat bei einer Weiterbildung der Schaltungsanordnung mit Kapselschicht mindestens eine Schicht des Schichtsystems eine größere Grundfläche als eine zwischen dieser Schicht und der Kontaktschicht liegende Schicht. Die Verbreiterung der Schichtflächen zur Kontaktschicht hin ist auf die geneigten Seitenwände einer bereits entfernten Maskenschicht zurückzuführen. Damit gelten die oben genannten technischen Wirkungen auch für die Schaltungsanordnung.

Bei Weiterbildungen der Schaltungsanordnungen haben die Schaltungsanordnungen Merkmale, die auch bei Schaltungsanordnungen entstehen, die mit dem erfindungsgemäßen Verfahren oder mit einer seiner Weiterbildungen hergestellt worden sind. So wird beispielsweise eine Versiegelungsschicht verwendet, die Seitenwände der Maskenschicht sind geneigt, die oben genannten Materialien werden eingesetzt und/oder die oben genannten Schichtdicken werden verwendet. Die oben genannten technischen Wirkungen gelten entsprechend für die Weiterbildungen.

Weiterhin betrifft die Erfindung ein Tunnelkontaktelement, das mindestens zwei elektrisch leitfähige Kontaktschichten enthält. Zwischen den Kontaktschichten liegt eine elektrisch nicht leitfähige Barriereschicht, deren Dicke so bemessen ist, dass sie von Elektronen nur aufgrund des Tunneleffektes durchquert werden kann. Die Barriereschicht und/oder eine Kontaktschicht wurde durch elektrochemische Abscheidung hergestellt. Durch diese Maßnahme kann die betreffende Schicht mit einer hohen Genauigkeit und gleichmäßigen Dicke hergestellt werden. Die Ausbeute der Herstellung der Tunnel-elemente ist sehr hoch.

Bei einer nächsten Weiterbildung wird die Barriereschicht durch anodische Oxidation hergestellt. Dabei wird eine der elektrisch leitfähigen Kontaktschichten als Elektrode für eine galvanische Abscheidung genutzt.

Bei einer Weiterbildung hat das Tunnelkontaktelement Merkmale, die auch bei einer Schaltungsanordnung auftreten, die nach dem erfindungsgemäßen Verfahren oder einer seiner Weiterbildungen hergestellt worden ist. Die oben genannten Merkmale und technischen Wirkungen gelten also auch für das Tunnelkontaktelement.

Im folgenden werden Ausführungsbeispiele der Erfindung an Hand der beiliegenden Zeichnungen erläutert. Darin zeigen:
- Figur 1: die Herstellung einer SiO₂-Struktur mit einer Überhang-Struktur (Reentrant), d.h. mit einer Verjüngung der Struktur noch oben hin,
- Figur 2: die Abscheidung eines unteren Metallkontaktes eines Tunnelelementes sowie einer oxidierbaren Schicht, z.B. einer Aluminiumschicht,
- Figur 3: die anodische Oxidation der Aluminiumschicht zur Herstellung einer Tunnelbarriere,
- Figur 4: das Aufbringen eines oberen Metallkontaktes des Tunnelelementes,
- Figur 5: das Auftragen einer Versiegelungsschicht z.B. aus SiO₂,
- Figur 6: die Versiegelungsschicht nach einem Einebnungsprozess,
- Figur 7: eine Struktur gemäß einem Ausführungsbeispiel mit organischen Materialien,
- Figur 8: die Struktur nach dem Ablösen einer organischen Maskenschicht,
- Figur 9: das Aufbringen einer Kapselschicht, und
- Figur 10: die Struktur mit eingeebneter Kapselschicht.

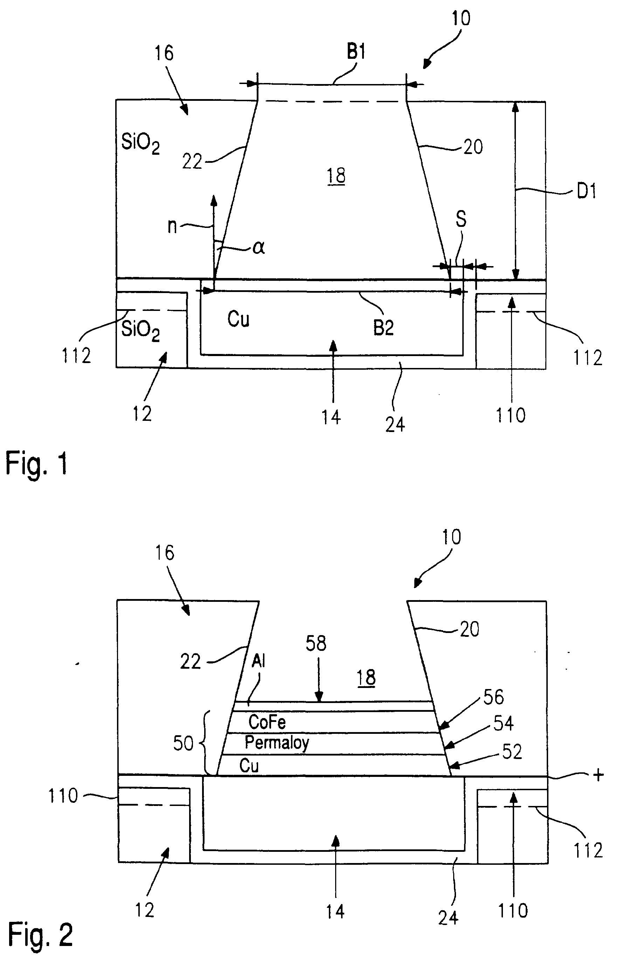

Figur 1 zeigt die Herstellung einer Struktur 10 mit z.B. trapezförmigem Querschnitt auf einer Substratschicht 12 z.B. aus Siliziumdioxid. In die Substratschicht 12 ist ein Leitbahnkontakt z.B. aus Kupfer in einem vorhergehenden Verfahrensschritt eingebettet worden. Diese Leitbahn wurde beispielsweise mit der sogenannten Damaszentechnik eingebettet. Zwischen Substratschicht 12 und Leitbahnkontakt 14 befindet sich eine etwa 5nm (Nanometer) dicke Barriereschicht z.B. aus Tantal-Nitrid. Auf der Substratschicht 12 und dem Leitbahnkontakt 14 wird eine Maskenschicht 16 z.B. aus Siliziumdioxid aufgebracht. Die Dicke D1 der Maskenschicht 16 ist größer als die Höhe eines herzustellenden Tunnelkontaktelementes.

Anschließend wird die Maskenschicht 16 mit Hilfe eines Trockenätzprozesses, z.B. eines reaktiven Ionenätzprozesses strukturiert, um z.B. die Struktur 10 mit trapezförmigem Querschnitt zu erzeugen. Eine solche Struktur wird auch als Reentrant-Struktur bezeichnet. Beim Ätzprozess entsteht ein Freiraum 18, dessen Seitenwände 20 und 22 bezüglich der Normalen n der Substratschicht 12 bzw. des Leitbahnkontaktes 14 um einen Winkel α > 3°, z.B. etwa 15°, geneigt sind. Entlang des in Figur 1 dargestellten Querschnittes hat die Öffnung des Freiraumes 18 eine Breite B1 von beispielsweise 180 nm. Der Freiraum 18 verbreitert sich zum Leitbahnkontakt 14 hin und hat am Leitbahnkontakt 14 eine Breite B2, die größer als die Breite B1 ist, z.B. 200 nm. In den Randbereichen des Leitbahnkontaktes 14 bleibt die Maskenschicht 16 stehen und überlappt den Leitbahnkontakt 14 um eine Überlappungsstrecke S von beispielsweise 20 nm. Das Ätzen wird beendet, wenn die Oberfläche des Leitbahnkontaktes 14 erreicht wird. Die Öffnung des Freiraumes 18 und seine Grundfläche sind beispielsweise quadratisch, rechteckförmig oder oval.

Figur 2 zeigt die Abscheidung eines unteren Kontaktstapels 50 des herzustellenden Tunnelelementes. Die Abscheidung erfolgt elektrochemisch unter der Verwendung von Außenstrom, d.h. galvanisch. Dabei wird ein positives Potential an die Barriereschicht 24 angelegt, die bis in die Randbereiche der Siliziumscheibe reicht, auf welcher sich die Struktur 10 befindet. Die Maskenschicht 16 ist hochohmig und wirkt somit als elektrischer Isolator. Der Leitbahnkontakt 14 leitet sehr gut und wirkt deshalb bei der Abscheidung als Anode. Auf dem Leitbahnkontakt 14 lagert sich zunächst eine Metallschicht 52 aus Kupfer in gleichmäßiger Dicke ab.

Anschließend wird in einem zweiten Abscheidungsprozess z.B. eine Permaloyschicht 54 auf der Kupferschicht 52 galvanisch abgeschieden. Auf der Permaloyschicht 54 wird in einem nächsten Abscheideprozess beispielsweise eine Kobalt-Eisen-Schicht 56 galvanisch abgeschieden. Auch die Kobalt-Eisen-Schicht 56 hat eine gleichmäßige Dicke. Die Dicken der Kupferschicht 52, der Permaleuschicht 54 und der Kobalt-Eisen-Schicht 56 betragen in dieser Reihenfolge beispielsweise 3 nm, 4 nm und 1 nm.

In einem nächsten Verfahrensschritt wird auf der Kobalt-Eisen-Schicht 56 galvanisch eine Aluminiumschicht 58 mit einer gleichmäßigen Dicke von z.B. 1,5 nm abgeschieden.

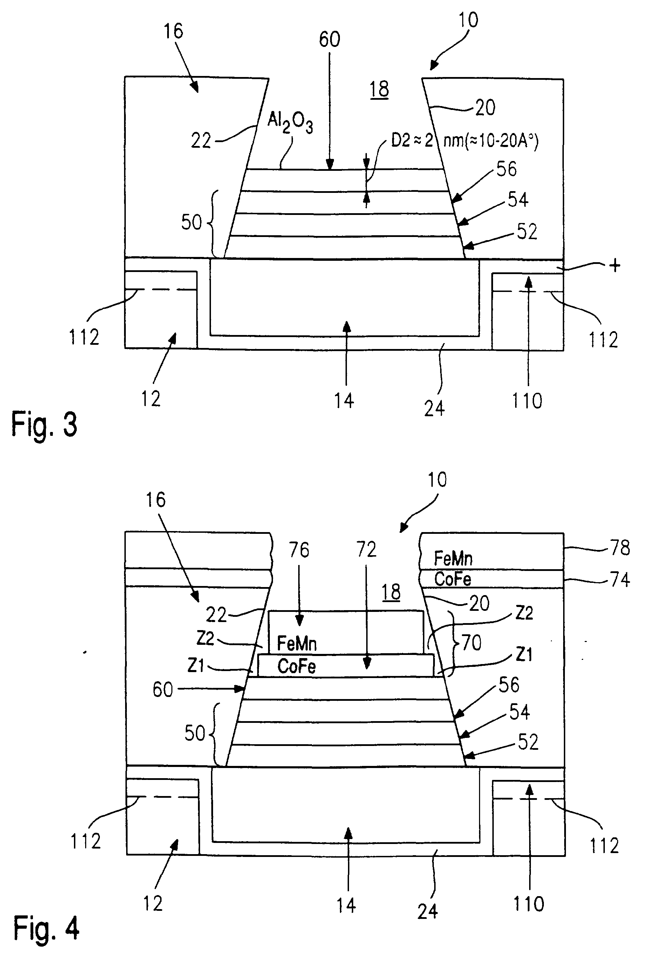

Figur 3 zeigt die anodische Oxidation der Aluminiumschicht 58 in eine Aluminiumoxidschicht 60. Der an der Anode ankommende Sauerstoff oxidiert die Aluminiumschicht 58 gleichmäßig zur Aluminiumoxidschicht 60. Am Ende des Oxidationsvorgangs hat die Aluminiumoxidschicht 60 eine Dicke von z.B. 2 nm. Die Aluminiumoxidschicht 60 bildet die Tunnelbarriere des herzustellenden Tunnelkontaktelementes.

Bei einem anderen Ausführungsbeispiel wird die Aluminiumschicht 58 nicht vollständig durchoxidiert, sondern nur teilweise. Es bleiben unter der Aluminiumoxidschicht 60 z.B. ein bis drei Atomlagen der Aluminiumschicht 58 erhalten.

Figur 4 zeigt das Aufbringen eines oberen Metallstapels 70 des herzustellenden Tunnelelementes. In einem ersten Prozessschritt, z.B. in einem Sputter-Prozess, wird auf die Aluminiumoxidschicht 60 eine z.B. etwa 2 nm dicke Kobalt-Eisen-Schicht 72 aufgebracht. Außerdem wird am Rand der Kobalt-Eisen-Schicht 72 ein Zwischenraum Z1 zwischen dieser Schicht und der Maskenschicht 16 gebildet. Dabei wird außerdem auf die Maskenschicht 16 eine Kobalt-Eisen-Schicht 74 aufgebracht.

In einem nächsten Prozessschritt wird auf die Kobalt-Eisen-Schicht 72 z.B. eine Eisen-Mangan-Schicht 76 aufgebracht. Die von der Eisen-Mangan-Schicht 76 eingenommene Fläche ist außerdem kleiner als die von der Kobalt-Eisen-Schicht 72 eingenommene Fläche. Zwischen Eisen-Mangan-Schicht 76 und der Maskenschicht 16 entsteht ein Zwischenraum Z2. Außerdem lagert sich eine Eisen-Mangan-Schicht 78 beim Aufbringen auf der Kobalt-Eisen-Schicht 74 ab.

Im Ausführungsbeispiel wird anschließend noch eine Diffusionsbarriere aus Tantal-Nitrid aufgebracht, um z.B. eine Diffusion von später aufzubringendem Kupfer zu verhindern. Diese Barriereschicht ist in Figur 4 nicht dargestellt.

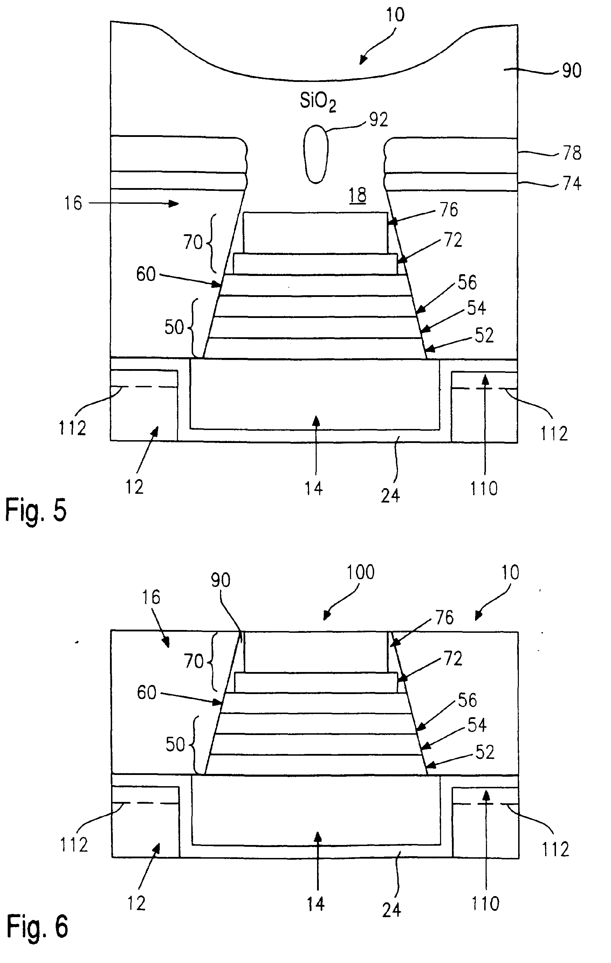

Figur 5 zeigt das Auftragen einer Versiegelungsschicht 90 z.B. aus Siliziumdioxid auf die Struktur 10. Die Dicke der Versiegelungsschicht 90 wird so gewählt, dass in einem nachfolgenden Poliervorgang das Polieren auf der Eisen-Mangan-Schicht 76 bzw. auf der darauf aufgebrachten Barriereschicht gestoppt werden kann. Ein Hohlraum 92 liegt oberhalb der Ebene, an der der Poliervorgang gestoppt wird, und istdeshalb nicht weiter störend. Die Versiegelungsschicht 90 dringt bis zur Aluminiumoxidschicht 60 in den noch verbliebenen Freiraum ein und füllt die noch verbliebenen Frei- und Zwischenräume mit Siliziumdioxid. Dadurch werden die Kobalt-Eisen-Schicht 72 und die Eisen-Mangan-Schicht 76 vollständig gekapselt. Außerdem lagert sich die Versiegelungsschicht oberhalb der Eisen-Mangan-Schicht 78 ab.

Figur 6 zeigt die eingeebnete Versiegelungsschicht 90. Eingeebnet wird mit Hilfe eines mechanisch-chemischen Polierprozesses. Der Polierprozess wird an der Oberfläche der Eisen-Mangan-Schicht 76 bzw. an der Oberfläche der darauf aufgebrachten Barriereschicht beendet. Beim Poliervorgang werden die auf der Maskenschicht 16 aufgebrachte Kobalt-Eisen-Schicht 74 und die darüber liegende Eisen-Mangan-Schicht 78 entfernt. Die Struktur 10 enthält nach dem Poliervorgang nur noch Teile der Versiegelungsschicht 90, die seitlich der Kobalt-Eisen-Schicht 72 und der Eisen-Mangan-Schicht 76 liegen. Nach dem Poliervorgang kann mit der Herstellung des oberen Leitbahnkontaktes begonnen werden. Durch den an Hand der Figuren 1 bis 6 erläuterten Herstellungsprozess entsteht ein Tunnelkontaktelement 100, dessen Schichten gleichmäßige Dicke haben. Insbesondere wird die Aluminiumoxidschicht 60 nicht von Materialien der darüberliegenden Kobalt-Eisen-Schicht 72 bzw. der Eisen-Mangan-Schicht 76 elektrisch kurzgeschlossen.

Die Barriereschicht 24 lässt sich in weiteren Verfahrensschritten von der Oberfläche der Struktur 10 her wieder durchtrennen. Dabei verbleiben um das Tunnelkontaktelement 100 herum Seitenwände aus dem Material der Maskenschicht 16 stehen.

Bei einem anderen Ausführungsbeispiel wird die Substratschicht 12 z.B. aus einem organischen und elektrisch nicht leitenden Material hergestellt. In diesem Fall wird die organische Substratschicht durch eine zusätzliche Hart-Maskenschicht 110 abgeschlossen, die beispielsweise aus SiON, SiO₂ oder Si₃N₄ besteht. Die Grenze zwischen der Maskenschicht 110 und der organischen Substratschicht ist in den Figuren 1 bis 6 durch gestrichelte Linien 112 dargestellt. Ansonsten bleiben die an Hand der Figuren 1 bis 6 erläuterten Verfahrensschritte und Materialien gleich.

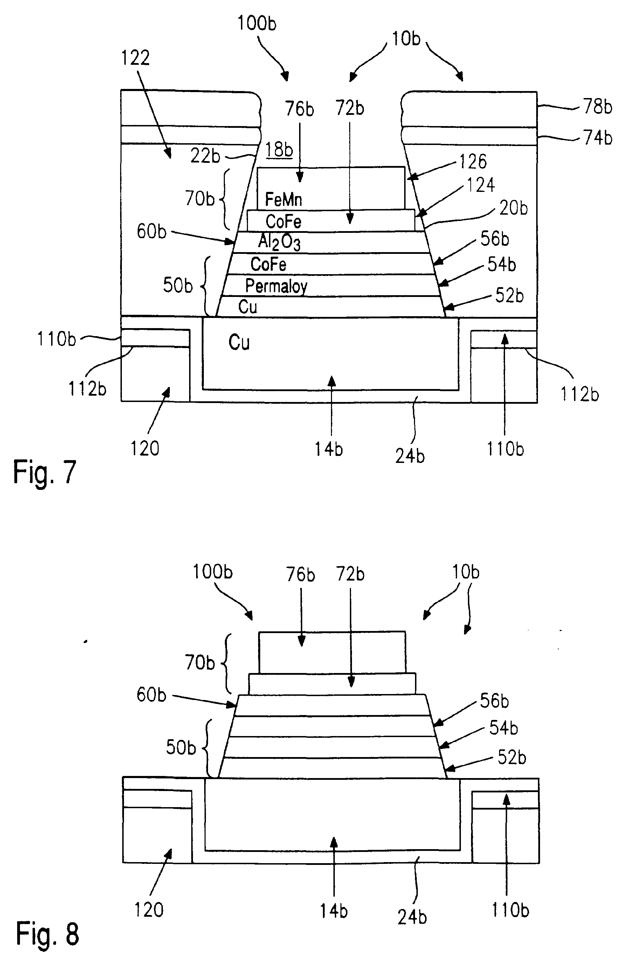

Figur 7 zeigt eine Struktur 10b gemäß einem Ausführungsbeispiel, bei dem anstelle der Substratschicht 12 einen Substratschicht 120 z.B. aus einem organischen Material verwendet wird. Über der Substratschicht 120 befindet sich beispielsweise eine Hart-Maskenschicht 110b. Auch bei dem in Figur 7 dargestellten Ausführungsbeispiel wird eine Barrierenschicht 24b zwischen Substratschicht 120 und Leitbahnkontakt 14b verwendet, um die Diffusion des Kupfers des Leitbahnkontaktes 14b in die Substratschicht 120 zu vermeiden. Auf die Barriereschicht 24b und den Leitbahnkontakt 14b wurde eine Maskenschicht 122 aus einem organischen Material aufgebracht. Im übrigen wurden zur Herstellung der Struktur 10b die gleichen Verfahrensschritte durchgeführt, die oben an Hand der Figuren 1 bis 6 für die Herstellung der Struktur 10 erläutert worden sind. Schichten aus gleichem Material, mit gleichen Abmessungen und der gleichen Funktion haben deshalb in Figur 7 das gleiche Bezugszeichen, jedoch mit dem nachgestellten Kleinbuchstaben b. Dies gilt für folgende Schichten:
- eine Kupferschicht 52b,
- eine Permaloyschicht 54b,
- eine Kobalt-Eisen-Schicht 56b,
- einen die Schichten 52b, 54b und 56b enthaltenden Kontaktstapel 50b,
- eine Aluminiumoxidschicht 60b,
- eine darauf aufgebrachte Kobalt-Eisen-Schicht 72b,
- eine Eisen-Mangan-Schicht 76b,
- einen die Schichten 72b und 76b enthaltenden Metallstapel 70b,
- eine auf der Maskenschicht 122 aufgebrachte Kobalt-Eisen-Schicht 74b, und
- eine darüberliegende Eisen-Mangan-Schicht 78b.

Seitenwände 20b und 22b entsprechen den Seitenwänden 20 und 22, d.h. die Seitenwände 20b und 22b sind in der Struktur 10b z.B. bezüglich des Leitbahnkontaktes 14b an der gleichen Stelle und mit der gleichen Neigung angeordnet, wie die Seitenwände 20 und 22 in der Struktur 10 bezüglich des Leitbahnkontaktes 14. Ein Freiraum 18b entspricht dem Freiraum 18.

Nach den Prozessschritten zur Herstellung der in Figur 7 dargestellten Struktur 10b wird in einem folgenden Prozessschritt die Maskenschicht 122 abgelöst. Zwischenräume 124 und 126 zwischen der Kobalt-Eisen-Schicht 72b und der Maskenschicht 122 sowie zwischen der Eisen-Mangan-Schicht 76b und der Maskenschicht 122 erleichtern das Eindringen eines Lösungsmittels und damit das Ablösen und Auflösen der Maskenschicht 122. Gemeinsam mit der Maskenschicht 122 werden auch die auf der Maskenschicht 122 liegenden Schichten 74b und 78b abgelöst.

Figur 8 zeigt die Struktur 10b nach dem Ablöseprozess. Dieser Prozess wird auch als Lift-Off-Prozess bezeichnet. Durch die Kombination zweier Beschichtungsverfahren, nämlich der elektrochemischen Abscheidung und des Sputterns, die Anwendung der anodischen Oxidation zur Herstellung der Tunnelbarriere 60b sowie die Anwendung des Lift-Off-Prozesses werden elektrische Kurzschlüsse über die Aluminiumoxidschicht 60b vermieden. Nach dem Ablösen der Maskenschicht 122 liegt die Barriereschicht 24b oberhalb der Hart-Maskenschicht 24b wieder frei. Auch die Seitenflächen des Tunnelkontaktelementes 100b werden beim Ablösen freigelegt.

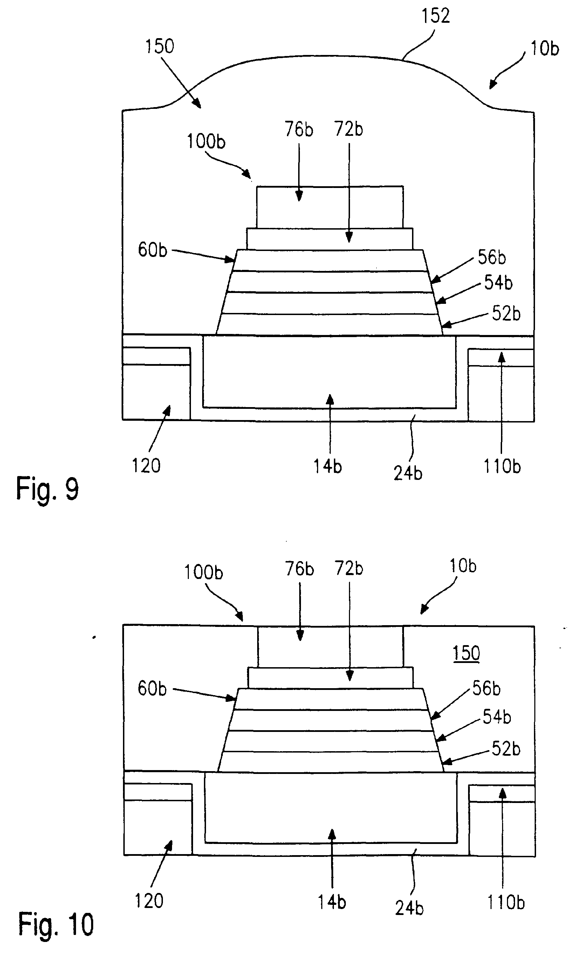

Figur 9 zeigt eine auf die Struktur 10b aufgebrachte Kapselschicht 150 z.B. aus einem organischen Material. Die Kapselschicht 150 wird in einer Dicke aufgebracht, die größer als die Höhe des Tunnelkontaktelementes 100b ist. Über dem Tunnelkontelement 100b bildet sich eine Erhebung 152. Die Kapselschicht 150 wird in einem folgenden Prozessschritt eingeebnet, beispielsweise durch einen mechanisch-chemischen Polierprozess.

Figur 10 zeigt die Struktur 10b am Ende des Polierprozesses. Der Polierprozess wurde an der oberen Fläche der Eisen-Mangan-Schicht 76b gestoppt. Damit ist die Herstellung des Tunnelkontaktelementes 100b im Wesentlichen beendet. In weiteren Verfahrensschritten werden z.B. ein oberer Leitbahnkontakt und weitere Bauelemente aufgebracht (nicht dargestellt).

Als Stoppschicht für den Polierprozess zum Einebnen der Kapselschicht 150 lässt sich auch eine vor dem Ablösen der Maskenschicht 122 aufgesputterte Diffusionsbarriere einsetzen.

Bei einem anderen Ausführungsbeispiel wird für die Substratschicht 120 ein anorganisches Material eingesetzt, z.B. Siliziumdioxid. In diesem Fall wird keine Hart-Maskenschicht 110b benötigt. Die Maskenschicht 122 besteht bei dem Ausführungsbeispiel aus einem organischen Material. Die Kapselschicht ist aus einem organischen Material.

Bei einem nächsten Ausführungsbeispiel besteht die Kapselschicht 150 aus einen anorganischen Material, z.B. aus Siliziumdioxid. Für die Maskenschicht 122 wird wieder ein organisches Material eingesetzt. Die Kapselschicht ist aus einem anorganischen Material.

### Bezugszeichenliste

- 10, 10b: Struktur
- 12: Substratschicht
- 14, 14b: Leitbahnkontakt
- 16: Maskenschicht
- D1: Dicke
- 18, 18b: Freiraum
- 20, 20b, 22, 22b: Seitenwand
- n: Normale
- α: Winkel
- B1, B2: Breite
- S: Überlappungsstrecke
- 24, 24b: Barriereschicht
- 50, 50b: unterer Kontaktstapel
- 52, 52b: Kupferschicht
- 54, 54b: Permaloyschicht
- 56, 56b: Kobalt-Eisen-Schicht
- 58: Aluminiumschicht
- 60, 60b: Aluminiumoxidschicht
- D2: Dicke
- 70, 70b: Metallstapel
- 72, 72b, 74, 74b: Kobalt-Eisen-Schicht
- 76, 76b, 78, 78b: Eisen-Mangan-Schicht
- 90: Versiegelungsschicht
- 92: Hohlraum
- 100, 100b: Tunnelkontaktelement
- 110, 110b: Maskenschicht
- 112, 112b: Grenze
- 120: organische Substratschicht
- 122: organische Maskenschicht
- 124, 126: Zwischenraum
- 150: Kapselschicht
- 152: Erhebung
- Z1, Z2: Zwischenraum

## Patentansprüche

1. Verfahren zum Herstellen einer integrierten Schaltungsanordnung,
bei dem auf eine von einer Substratschicht (12; 120) getragene elektrisch leitfähige Kontaktschicht (14; 14b) eine elektrisch nicht leitfähige Maskenschicht (16; 122) aufgebracht wird,
die Maskenschicht (16; 122) von einem Teilbereich der elektrisch leitfähigen Kontaktschicht (14; 14b) entfernt wird,
und bei dem in dem entstandenen Freiraum (18; 18b) mittels elektrochemischer Abscheidung mindestens eine elektrisch leitfähige Schicht (52 bis 56; 52b bis 56b) abgeschieden wird,
wobei die zuletzt abgeschiedene Schicht in einem Oxidationsvorgang vollständig oder teilweise zu einer elektrisch nicht leitfähige Schicht (60; 60b) umgewandelt wird,
oder wobei auf die zuletzt abgeschiedene Schicht eine elektrisch nicht leitfähige Schicht aufgebracht wird,
wobei auf die elektrisch nicht leitfähige Schicht (60; 60b) mindestens eine weitere Schicht (72, 76; 72b, 76b) aufgebracht wird,
wobei die weitere Schicht (72, 76; 72b, 76b) im Freiraum (18; 18b) liegt,
und wobei mindestens eine beim Aufbringen der weiteren Schicht (72, 76; 72b, 76b) außerhalb des Freiraums (18; 18b) entstandene Schicht (74, 78; 74b, 78b) in einem Abtragungsprozess abgetragen wird.

2. Verfahren nach Anspruch 1,
**dadurch gekennzeichnet,**
**dass** die Maskenschicht (16) die elektrisch leitfähige Kontaktschicht (14, 24) allseitig überlappt
und **dass** nacheinander elektrisch leitfähige Schichten (52 bis 56) aus verschiedenen Materialien abgeschieden werden.

3. Verfahren nach Anspruch 1 oder 2,
**dadurch gekennzeichnet,**
**dass** beim Abtragungsprozess die Maskenschicht in Höhe der abgeschiedenen Schichten und der aufgebrachten Schichten verbleibt.

4. Verfahren nach Anspruch 3,
**dadurch gekennzeichnet,**
**dass** vor dem Abtragungsprozess eine Versiegelungsschicht (90) aufgebracht wird, die den noch nicht gefüllten Raum des Freiraums (18) einnimmt,
und **dass** die Versiegelungsschicht (90) beim Abtragungsprozess bis auf die Höhe der obersten aufgebrachten Schicht (76) abgetragen wird.

5. Verfahren nach Anspruch 1 oder 2,
**dadurch gekennzeichnet,**
**dass** beim Abtragungsprozess auch die Maskenschicht (122) abgetragen wird.

6. Verfahren nach Anspruch 5,
**dadurch gekennzeichnet,**
**dass** die Maskenschicht (122) aus einem organischen Material besteht,
und das die Maskenschicht (122) mit Hilfe eines vorzugsweise organischen Lösungsmittels abgelöst wird.

7. Verfahren nach Anspruch 5 oder 6,
**dadurch gekennzeichnet,**
**dass** nach dem Abtragen der Maskenschicht (122) eine Kapselschicht (150) aufgebracht wird,
und **dass** die Kapselschicht (150) bis auf die Höhe der zuletzt aufgebrachten Schicht (76b) abgetragen wird, vorzugsweise mit einem mechanisch-chemischen Polierprozess.

8. Verfahren nach einem der vorhergehenden Ansprüche,
**dadurch gekennzeichnet,**
**dass** ein Teil der Maskenschicht (16) vorzugsweise durch anisotrophes Ätzen so entfernt wird, dass sich der Freiraum (18) vorzugsweise allseitig zur Substratschicht (12) hin verbreitert.

9. Verfahren nach Anspruch 8,
**dadurch gekennzeichnet,**
**dass** der Freiraum (18) einen trapezförmigen Querschnitt hat.

10. Verfahren nach einem der vorhergehenden Ansprüche,
**dadurch gekennzeichnet,**
**dass** eine Vielzahl von Freiräumen (18) mit gleichartigen Bauelementen (100) in der Maskenschicht (18) angeordnet sind,
und **dass** die Kontaktschichten (14) mehrerer Bauelemente (1009) miteinander verbunden sind.

11. Verfahren nach einem der vorhergehenden Ansprüche,
**dadurch gekennzeichnet,**
**dass** die Maskenschicht (16) dünner als 100 nm, vorzugsweise dünner als 50 nm ist,
und/oder dass mindestens eine der in den Freiraum (18) eingebrachten Schichten (60) dünner als 5 nm ist.

12. Verfahren nach einem der vorhergehenden Ansprüche,
**dadurch gekennzeichnet,**
**dass** mindestens eine in den Freiraum (18) eingebrachte Schicht (60) aus einem elektrisch nicht leitfähigen Material besteht,
und **dass** diese Schicht eine gleichmäßige Dicke hat, die vorzugsweise so bemessen ist, dass Elektronen die Schicht nur aufgrund des Tunneleffektes durchqueren können.

13. Verfahren nach Anspruch 12,
**dadurch gekennzeichnet,**
**dass** die Schicht (60) aus einem elektrisch leitfähigen Material durch elektrochemische Abscheidung eingebracht wird,
**dass** die Schicht vorzugsweise durch anodische Oxidation zu der elektrisch nicht leitfähigen Schicht (60) oxidiert wird,
und/oder dass die Schicht vorzugsweise teilweise oder vollständig oxidiert wird.

14. Verfahren nach einem der vorhergehenden Ansprüche,
**dadurch gekennzeichnet,**
**dass** die Substratschicht (12) ein Quarzglas oder ein anorganisches elektrisch nicht leitfähiges Material enthält,
und/oder dass die Maskenschicht (16) und/oder die Versiegelungsschicht (90) ein Quarzglas oder ein anorganisches elektrisch nicht leitfähiges Material enthält,
und/oder dass die zuletzt abgeschiedene Schicht (60) ein Metall enthält, das ein stabiles Oxid bildet, vorzugsweise Aluminium,
und/oder dass im Freiraum (18) mindestens eine Schicht (54, 56) aus einem hartmagnetischen Material und/oder mindestens eine Schicht (72, 76) aus einem weichmagnetischen Material angeordnet ist.

15. Schaltungsanordnung (10),
mit einer Substratschicht (12), die eine elektrisch leitfähige Kontaktschicht (14) trägt,
mit einer die Kontaktschicht (14) allseitig überlappenden elektrisch nicht leitfähigen Maskenschicht (16), die ein Schichtsystem (50, 60, 70) einschließt, das mindestens eine durch elektrochemische Abscheidung abgeschiedene Schicht (52 bis 56, 60) enthält,
wobei die Maskenschicht (16) älter als die abgeschiedene Schicht (52, 54, 60) ist,
**dadurch gekennzeichnet,**
**dass** die Maskenschicht (16) eine Dicke (D1) hat, die mindestens der Höhe des Schichtsystems (50, 60, 70) entspricht,
und **dass** im Schichtsystem (50, 60, 70) mindestens eine elektrisch nicht leitende Schicht (60) enthalten ist, die zwischen einzelnen Schichten (56, 72) des Schichtsystems (50, 60, 70) liegt.

16. Schaltungsanordnung (10b),
mit einer Substratschicht (120), die eine elektrisch leitende Kontaktschicht (14b) trägt,
mit einer Kapselschicht (150) die ein Schichtsystem (50b, 60b, 70b) aus mehreren Schichten , von denen mindestens eine Schicht (52b bis 56b, 60b) durch elektrochemische Abscheidung abgeschieden worden ist,
wobei die Kapselschicht (150) jünger als die abgeschiedene Schicht (52b bis 56b, 60b) ist,
und wobei die Seitenränder der Schichten von Materialien anderer Schichten des Schichtsystems frei sind.

17. Schaltungsanordnung (10b) nach Anspruch 16,
**dadurch gekennzeichnet,**
**dass** mindestens eine Schicht des Schichtsystems eine größere Grundfläche hat, als eine zwischen dieser Schicht und der Kontaktschicht (14b) liegende Schicht.

18. Schaltungsanordnung (10) nach einem der Ansprüche 15 bis 17,
**dadurch gekennzeichnet,**
**dass** sie Merkmale hat, die auch bei Schaltungsanordnungen entstehen, die mit einem Verfahren gemäß einem der Ansprüche 1 bis 14 hergestellt worden sind.

19. Tunnelkontaktelement (100, 100b),
mit mindestens zwei elektrisch leitfähigen Kontaktschichten (14),
und mit einer zwischen den Kontaktschichten liegenden elektrisch nicht leitfähigen Barriereschicht (60), deren Dicke (D2) so bemessen ist, dass sie von Elektronen nur aufgrund des Tunneleffektes durchquert werden kann,
**dadurch gekennzeichnet,**
**dass** eine Kontaktschicht (14) und/oder die Barriereschicht (60) durch elektrochemische Abscheidung abgeschieden worden sind.

20. Tunnelkontaktelement (100, 100b),
mit mindestens zwei elektrisch leitfähigen Kontaktschichten (14),
und mit einer zwischen den Kontaktschichten liegenden elektrisch nicht leitfähigen Barriereschicht (60), deren Dicke (D2) so bemessen ist, dass sie von Elektronen nur aufgrund des Tunneleffektes durchquert werden kann,
**dadurch gekennzeichnet,**
**dass** die Barriereschicht (60) durch anodische Oxidation hergestellt worden ist.

21. Tunnelkontaktelement nach Anspruch 19 oder 20, **dadurch gekennzeichnet,**
**dass** es Merkmale hat, die auch bei einer Schaltungsanordnung auftreten, die mit einem Verfahren gemäß einem der Ansprüche 1 bis 14 hergestellt worden ist.
